Europäisches Patentamt

European Patent Office

Office européen des brevets

(19)

(11) Numéro de publication: **0 049 235**
**A1**

(12) **DEMANDE DE BREVET EUROPEEN**

(21) Numéro de dépôt: **81870038.7**

(22) Date de dépôt: **23.09.81**

(51) Int. Cl.³: **H 02 J 9/06,** H 02 H 3/24,
G 01 R 19/165

(30) Priorité: **25.09.80 LU 82801**

(43) Date de publication de la demande: **07.04.82**
**Bulletin 82/14**

(84) Etats contractants désignés: **AT BE CH DE FR GB IT LI NL SE**

(71) Demandeur: **CONSTRUCTIONS ELECTRIQUES ET ELECTRONIQUES en abrégé, C.E.T. Société Anonyme, 472, rue Saint-Léonard, B-4000 Liege (BE)**

(72) Inventeur: **De Pra, Ugo, 51, rue de Wixhou, B-4531 Argenteau (BE)**

(74) Mandataire: **van Malderen, Michel et al, p.a. FREYLINGER & ASSOCIES 85, Boulevard de la Sauvenière(Bte 42), B-4000 Liége (BE)**

(54) Procédé de détection de perturbations d'une tension électrique alternative provoquant la commutation de l'utilisation vers une autre source de courant.

(57) Procédé de détection de perturbations d'une tension électrique alternative provoquant la commutation de l'utilisation vers une autre source de courant selon lequel on analyse la valeur instantanée de la tension en la comparant à sa valeur nominale et on commande la commutation sur cette autre source en cas d'anomalie de la tension.

On échantillonne en permanence la tension et on convertit chaque valeur de l'échantillon en une valeur numérique, on compare cette valeur numérique à la valeur nominale théorique qu'elle devrait avoir, les valeurs théoriques ainsi que les écarts tolérés de ces valeurs théoriques étant préalablement mis en mémoire, on commute automatiquement sur l'autre source et déconnecte, après un laps de temps où les sources se recouvrent, la source contrôlée lorsqu'un nombre prédéterminé de comparaisons successives révèle des écarts, en valeur absolue, entre l'échantillon de tension concerné et la valeur nominale théorique correspondante qui sont supérieurs à l'écart toléré mémorisé pour cette valeur.

L'utilisation de valeurs numérique et d'une logique programmable confère une grande flexibilité.

Fig. 1

- 1 -

## Procédé de détection de perturbations d'une tension électrique alternative provoquant la commutation de l'utilisation vers une autre source de courant

La présente invention concerne un procédé de détection de perturbations d'une tension électrique alternative provoquant la commutation de l'utilisation vers une autre source de courant selon lequel on analyse la valeur instantanée de la tension en la comparant à sa valeur nominale, et on commande la commutation sur cette autre source en cas d'anomalie de la tension.

Ce procédé s'applique plus particulièrement aux alimentations d'installations ou appareils que l'on veut, ou que l'on doit soustraire aux défaillances ou perturbations éventuelles d'alimentation électrique. Toutefois, étant donné qu'il est extrêmement difficile, voire impossible d'éliminer complètement les risques d'une défaillance d'alimentation électrique, on prévoit généralement un système de détection de perturbations, ou de signes de perturbations de l'alimentation électrique et on se sert des résultats de cette détection pour commander automatiquement la commutation sur une seconde source de courant.

Les moyens de détection utilisés à cet effet sont, en général , des moyens électro-mécaniques, ou plus récemment, électroniques. Ces moyens électroniques fonctionnent par principes analogiques et le principal défaut qu'on leur reproche actuellement est d'être trop lents pour procéder à la détection d' une anomalie lorsque la détection se fait au niveau de l'onde délivrée à l'utilisation.

Le but de la présente invention est de prévoir un nouveau procédé de détection électronique des perturbations d'une onde électrique, qui soit plus rapide,plus précis et plus flexibles que les procédés actuellement connus.

Pour atteindre cet objectif, le procédé selon l'invention est essentiellement caractérisé en ce que l'on échantillonne en permanence la tension et on convertit chaque valeur de l'échantillon en une valeur numérique, en ce que l'on compare cette valeur numérique à la valeur nominale théorique qu'elle devrait avoir, les valeurs théoriques ainsi que les écarts tolérés de ces valeurs théoriques étant préalablement mis en mémoire, en ce que l'on commute automatiquement sur l'autre source et déconnecte, après un laps de temps où les sources se recouvrent, la source contrôlée lorsqu'un nombre prédéterminé de comparaisons successives révèle des écarts, en valeur absolue, entre l'échantillon de tension concerné et la valeur nominale théorique correspondante qui sont supérieurs à l'écart toléré mémorisé pour cette valeur.

Le temps de détection d'une perturbation ou anomalie dépend essentiellement de la finesse de l'échantillonnage et du nombre prédéterminé de comparaisons que l'on s'impose avant de commander la commutation. En tout état de cause, il est possible de faire la détection et la commutation en moins d'une demi-période, c'est-à-dire dix milli-secondes pour une onde de tension à 50 Hz.

En outre, la commutation vers la seconde source est réalisée sans coupure de courant car, hormis le cas d'un court-circuit, la détection de l'anomalie et la commutation sont effectuées avant que la tension ne tombe à zéro.

Avantageusement le passage par zéro de la tension de la seconde source est mis à profit pour évaluer l'écart de phase en mesurant la tension, en cet instant, de la première source , de manière que si l'écart de phase tolérable prédéterminé est dépassé, toute procédure de transfert soit bloquée.

Selon l'invention il est avantageux que l'échantillonnage et l'analyse numérique soient effectués au moyen de circuits logiques, de préférence programmables tel qu'un microprocesseur associé à des mémoires RAM et ROM.

Le passage par zéro de la tension contrôlée n'influence pas la comparaison. Autrement dit, le nombre prédéterminé de comparaisons successives pris en considération pour déterminer s'il y a anomalie ou non, peut s'étaler sur deux demi-périodes successives et en conséquence, le passage par zéro de la tension contrôlée n'est pas pris en considération pour ledit nombre prédéterminé de comparaisons successives selon une forme d'exécution préférée.

3

Selon une autre particularité de l'invention, on commute à nouveau sur la source de courant initiale dès que les perturbations de celle-ci auront disparu. A cet effet, après avoir commuté sur l'autre source, on continue de préférence le contrôle de la source précédemment perturbée en effectuant des contrôles à intervalles réguliers et l'on commute, à nouveau, sur la source initiale dès que les perturbations de celle-ci ont disparu. Avantageusement, dans ce cas, après avoir commuté à nouveau sur la source initiale, on ne recommence le processus d'échantillonnage et de détection d'anomalies qu'après quelques périodes de tension, ceci afin d'éviter la détection d'anomalies causées par la commutation.

Afin de ne recourir qu'à des valeurs positives lors de la comparaison, on effectue un redressement préalable de la tension.

Différents dispositifs visant à exécuter des fonctions similaires ont été décrits dans CH-A-497 805 (AGIE), DE-A- 2 025 005 (FRAKO), ISA.TRANSACTIONS, Vol 11, 1102,1972, PITTSBURGH (US) - G.S. Hope et al. "Power Transmission Line Abnormalities : Analysis and Detection" pages 168-177 et FR-A 1 565 838 (BORG-WARNER).

Comparée aux solutions proposées dans ces références l'invention a l'avantage d'utiliser des valeurs numériques et une logique programmable, ce qui confère au système une flexibilité très grande puisque les critères et grandeurs retenus peuvent être modifiés sans altérer les circuits, il suffit en effet de changer le programme d'exécution de la mémoire morte.

A noter également qu'il est loisible de contrôler simultanément l'onde de l'onduleur et celle de la source de réserve puisque la comparaison des valeurs numériques se fait avec des valeurs nominales absolues tenues en mémoire: on évite ainsi de transférer la charge sur une source de réserve non conforme.

D'autres particularités et avantages de l'invention ressortiront à la lecture d'un exemple de mise en oeuvre présenté ci-dessous, à titre d'illustration, en référence aux figures annexées dans lesquelles :

La figure 1 présente un schéma synoptique d'un circuit pour la mise en oeuvre de l'invention dans une application particulière et

la figure 2 illustre schématiquement l'échantillonnage d'une tension alternative redressée.

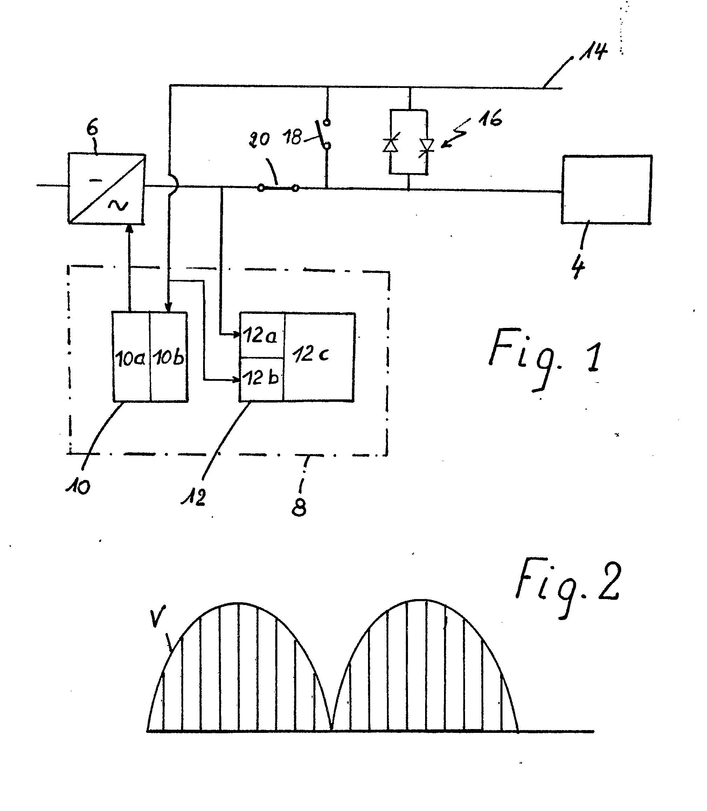

La figure 1 montre l'application du procédé selon l'invention à un circuit de conditionnement du courant du réseau en vue de l'alimentation d'une installation ou d'un appareil nécessitant l'intervention d'un tel circuit. C'est le cas, notamment, de certains ordinateurs, d'instruments de télémesure, bref de tous les appareils nécessitant un courant et une tension d'alimentation plus stables et plus constants que l'alimentation directe par le réseau. A cet effet, on prévoit généralement un circuit redresseur pour redresser le courant du réseau. A l'aide de ce courant redressé, on alimente une batterie dont la tension de sortie est, à nouveau, tranformée dans un onduleur pour obtenir une tension alternative destinée à alimenter l'appareil ou l'installation en question. Cet appareil ou installation que l'on appelera "utilisateur" est représenté par la référence 4, tandis que l'"onduleur" destiné à délivrer une tension à amplitude constante est représenté par la référence 6.

Le procédé selon l'invention sert, par conséquent, à détecter des perturbations, souvent passagères, de l'onde électrique engendrée par l'onduleur 6, perturbations dues à une anomalie de fonctionnement du circuit de conditionnement. Dans l'exemple représenté, on supposera que l'onduleur 6 délivre une onde sinusoïdale de tension stable, à une fréquence de 50 Hz.

La référence 8 désigne un bloc de commande comprenant, entre autres, un circuit de commande 10 synchronisé par la tension du réseau représenté par 14. Ce circuit de commande 10 engendre des impulsions de commande pour mettre l'onduleur 6 en synchronisme avec la tension du réseau 14.

Le bloc de commande 8 comporte également un circuit de détection 12, composé de circuits logiques (éléments discrets et/ou micro-processeurs) destinés au traitement des données numériques acquises en temps réel et à engendrer des signaux de sortie si l'analyse de l'onde délivrée par l'onduleur 6 révèle une anomalie. Ces signaux de sortie engendrés par le circuit de détection 12 sont appliqués à un interrupteur électronique 16 et un interrupteur électro-mécanique 18 pour brancher l'utilisateur 4 sur le réseau 14 ainsi qu'à un interrupteur électro-mécanique 20 pour déconnecter l'utilisateur 4 de l'onduleur 6.

On va maintenant expliquer en détail le fonctionnement du circuit représenté par la figure 1 ainsi que le procédé mis en oeuvre.

L'onde sinusoïdale engendrée par l'onduleur 6 est redressée et échantillonnée dans le circuit 12 à une cadence prédéterminée, par exemple, à la cadence de une milli-seconde. Autrement dit, si l'onde délivrée par l'onduleur 6 a une fréquence de 50 Hz, c'est-à-dire une période de 20 milli-secondes, chaque demi-période de la tension V de l'onduleur 6 est échantillonnée en dix signaux qui sont convertis en valeur numérique. Cet échantillonnage est représenté schématiquement par la figure 2.

Dans le circuit 12 sont mémorisées dix valeurs numériques correspondant aux amplitudes nominales théoriques de l'onde à délivrer par l'onduleur 6 comme, par exemple, représenté à la figure 2. Un circuit de comparaison, connu en soi, compare chacun des signaux échatillonnés de l'onde produite par l'onduleur 6 à la valeur optimale de l'échantillon correspondant mémorisé. Si cette comparaison révèle une différence et que cette différence dépasse un écart prédéterminé, fixé arbitrairement en fonction de la précision exigée, par exemple 15 % de la valeur mémorisée, le circuit 12 déclenche un signal d'anomalie. Ce signal d'anomalie est

6

introduit dans le compteur dont le compte progresse d'une unité. Si le compte de ce compteur atteint un nombre prédéterminé, par exemple 5, il produit un signal aux sorties du circuit 12. Par contre, ce compteur est remis à zéro chaque fois que la comparaison ne révèle pas de différence entre les valeurs comparées ou une différence inférieure à l'écart prédéterminé. Autrement dit, le signal de sortie du circuit 12 n'est déclenché que lorsque cinq comparaisons successives déclenchent des signaux d'anomalie.

Il est bien entendu possible de fixer arbitrairement le nombre de signaux d'anomalies nécessaire pour déclencher un signal à la sortie du circuit 12. De même, on pourra changer l'importance de l'écart nécessaire entre les valeurs comparées pour qu'il y ait un signal d'anomalie.

Les perturbations les plus fréquentes de l'onde sinusoïdale engendrées par l'onduleur 6 sont une croissance ou une décroissance de l'amplitude de la tension. Une autre perturbation est le court-circuit, c'est-à-dire une chute instantanée de la tension. Le temps nécessaire à la détection d'une telle perturbation est, dans le cas de l'exemple précité, c'est-à-dire avec un échantillonnage à la cadence d'une milli-seconde et la condition de cinq signaux successifs d'anomalies, égal à un quart de période.

Si un signal, suite à une perturbation prolongée de la tension de sortie de l'onduleur 6 se présente à la sortie du circuit 12, ce signal allume l'interrupteur électronique 16 pour brancher l'utilisateur 4 sur le réseau 14. L'interrupteur électronique 16 peut être constitué par des moyens connus en soi comme, par exemple, thyristors ou triacs. Ce signal de sortie, déclenché par le circuit 12, ferme également un interrupteur électro-mécanique 18 destiné à court-circuiter l'interrupteur électronique 16 et ouvre, en même temps, un interrupteur 20 pour débrancher l'onduleur 6. L'interrupteur électronique 16 s'éteint automatiquement par la fermeture de l'interrupteur 18, laissant l'utilisateur 4 directement sur le réseau 14.

Il va de soi que, pour que l'on puisse commuter l'utilisateur 4 de l'onduleur 6 vers le réseau 14, ce dernier doit être en synchronisme avec l'onduleur 6. Toutefois,

7

dans l'exemple représenté, cette condition est réalisée automatiquement, étant donné que le réseau 14 influence les impulsions de cadence à l'onduleur 6 par l'intermédiaire du circuit 10.

Si l'utilisateur 4 exige une précision de la tension d'alimentation telle que celle du réseau 14 ne soit pas apte à alimenter l'utilisateur 4, il est possible de prévoir un circuit de conditionnement de réserve, sur lequel on commute l'alimentation de l'utilisateur 4 en cas d'anomalie du circuit initial détectée par le circuit 12.

En cas de court-circuit sur l'utilisation, l'onduleur 6 est capable d'actionner les dispositifs de protection (fusibles, disjoncteurs) pendant les cinq premières milli-secondes, s'ils sont correctement calibrés. Si le court-circuit persiste plus de cinq milli-secondes, il faut transférer l'utilisation sur le réseau pour actionner le dispositif de protection.

Lorsque l'utilisateur 4 est connecté au réseau 14 par l'interrupteur 18, on vérifie, à intervalles réguliers, par exemple, toutes les cinq secondes, si les perturbations de l'onduleur 6 n'ont pas disparu. Si ces détections révèlent que la situation est redevenue normale, on commute à nouveau vers l'onduleur 6 en allumant l'interrupteur électronique 16, en ouvrant l'interrupteur 18, en fermant l'interrupteur 20 et en éteignant l'interrupteur électronique 16. Toutefois, après cette commutation sur l'onduleur 6, on ne recommence les vérifications de la tension délivrée par celui-ci qu'après un délai prédéterminé , par exemple, après deux périodes, pour éviter de détecter les anomalies provenant de la phase de commutation.

Le démarrage de l'échantillonnage se fait sur le passage par zéro de la tension de la source de réserve.

Cette façon de procéder permet de décréter par calcul la perte de synchronisme et dans ce cas d'interdire tout transfert.

Pour ce faire :

1) on mesure la valeur de la tension de l'onduleur lorsque la source de réserve a sa tension qui passe par zéro.

2) si cette valeur dépasse un seuil prédéterminé, par exemple celui corresondant à E sin 10° (E représente la valeur maximum de la tension nominale de V), on

8

empêche tout transfert.

On ne peut en effet transférer la charge sans coupure que si l'erreur de phase des tensions de l'onduleur et du réseau ne dépasse pas une certaine valeur.

La figure 1 donne des précisions sur l'organisation du bloc de commande 8, particulièrement lorsque l'onde du réseau 14 est également analysée.

Dans ce bloc,

10 a représente le générateur de commande proprement dit de l'onduleur,

le synchronisateur 10 b a pour but de maintenir via le pilotage du générateur 10 a, les tensions du réseau 14 et de l'onduleur 6 synchrones en valeur et en phase.

12 a est le bloc délivrant les grandeurs numériques des échantillons de la tension de l'onduleur à l'unité de traitement et d'action 12 c, ce bloc 12 a comporte un système de redressement, d'échantillonnage et de conversion analogique/digital.

12 b représente le bloc délivrant les grandeurs numériques des échantillons de la tension du réseau à l'unité de traitement et d'action 12 c et il comporte les mêmes éléments que le bloc 12 a.

Finalement 12 c représente l'unité de traitement et d'action. Elle comporte un microprocesseur, des mémoires RAM et EPROM, des relais reed et optocoupleur, ainsi que la commande des thyristors 16. Cette unité permet le traitement des échantillons numériques fournis par 12 a et 12b et l'action, selon les valeurs des échantillons, sur les thyristors 16 et les contacteurs 18 et 20.

Il est bien entendu que l'invention n'est pas limitée à l'exemple particulier d'application décrit ci-dessus, mais qu'elle est applicable, d'une façon générale, pour commuter un utilisateur d'un réseau vers un autre, et vice versa, la seule condition nécessaire étant que la fréquence des tensions des deux réseaux soit la même, peu importe la valeur de cette fréquence, et qu'ils soient synchronisables.

9

REVENDICATIONS

1. Procédé de détection de perturbations d'une tension
électrique alternative provoquant la commutation de l'utilisation vers une autre source de courant selon lequel on analyse
la valeur instantanée de la tension en la comparant à sa valeur
nominale et on commande la commutation sur cette autre source
en cas d'anomalie de la tension, caractérisé en ce que l'on
échantillonne en permanence la tension et on convertit chaque
valeur de l'échantillon en une valeur numérique, en ce que
l'on compare cette valeur numérique à la valeur nominale théorique qu'elle devrait avoir, les valeurs théoriques ainsi que
les écarts tolérés de ces valeurs théoriques étant préalablement mis en mémoire, en ce que l'on commute automatiquement
sur l'autre source et déconnecte, après un laps de temps où
les sources se recouvrent, la source contrôlée lorsqu'un nombre
prédéterminé de comparaisons successives révèle des écarts, en
valeur absolue, entre l'échantillon de tension concerné et la
valeur nominale théorique correspondante qui sont supérieurs à
l'écart toléré mémorisé pour cette valeur.

2. Procédé selon la revendication 1, caractérisé en
ce que le passage par zéro de la tension de la seconde source
est mis à profit pour évaluer l'écart de phase en mesurant la
tension, en cet instant, de la première source de manière que si
l'écart de phase tolérable prédéterminé est dépassé, toute
procédure de transfert soit bloquée.

3. Procédé selon l'une quelconque des revendications
1 ou 2, caractérisé en ce que l'échantillonnage et l'analyse
numérique sont efectués au moyen de circuits logiques, de préférence programmables tel qu'un microprocesseur associé à des
mémoires RAM et ROM.

4. Procédé selon la revendication 1, caractérisé en
ce que le passage par zéro de la tension contrôlée n'est pas
pris en considération pour ledit nombre prédéterminé de comparaisons successives.

5. Procédé selon l'une quelconque des revendications
1 à 4, caractérisé en ce que après avoir commuté sur l'autre
source, on continue le contrôle de la source précédemment perturbée en effectuant des contrôles à intervalles réguliers, et
en ce que l'on commute, à nouveau, sur la source initiale dès

10

que les perturbations de celle-ci ont disparu.

6. Procédé selon la revendication 5, caractérisé en ce que, après avoir commuté, à nouveau sur la source initiale, on ne recommence le processus d'échantillonnage et de détection d'anomalies qu'après quelques périodes de tension.

1/1

Fig. 1

Fig. 2

Office européen
des brevets

**RAPPORT DE RECHERCHE EUROPEENNE**

Numéro de la demande

EP 81 87 0038

| DOCUMENTS CONSIDERES COMME PERTINENTS | | CLASSEMENT DE LA DEMANDE (Int. Cl. 3) |
|---|---|---|

| Catégorie | Citation du document avec indication, en cas de besoin, des parties pertinentes | Revendication concernée |
|---|---|---|
| D | CH - A - 497 805 (AGIE)<br><br>* en entier * | 1,4 |
| D | DE - A - 2 025 005 (FRAKO)<br><br>* en entier * | 1,3,4 |
| D | ISA TRANSCATIONS, vol. 11, no. 2, 1972, PITTSBURGH (US) G.S. HOPE et al.: "Power Transmission Line Abnormalities: Analysis and Detection", pages 168-177<br><br>* page 168, paragraphe: "Introduction"; page 173, paragraphe: "Topological method of pattern recognition"; figures 5 et 6; pages 175 et 176, paragraphe: "Interface unit"; figure 9 * | 1,3 |
| D | FR - A - 1 565 838 (BORG-WARNER)<br><br>* page 1, lignes 1-17; page 3, ligne 13 à page 4, ligne 2; page 12, lignes 13-35; figure 1 * | 3,5,6 |

**CLASSEMENT DE LA DEMANDE (Int. Cl. 3)**

H 02 J 9/06
H 02 H 3/24
G 01 R 19/165

**DOMAINES TECHNIQUES RECHERCHES (Int. Cl. 3)**

H 02 J 9/06
H 02 H 3/247
3/24
3/50
G 01 R 29/02
19/165
G 06 K 9/68

**CATEGORIE DES DOCUMENTS CITES**

X: particulièrement pertinent à lui seul
Y: particulièrement pertinent en combinaison avec un autre document de la même catégorie
A: arrière-plan technologique
O: divulgation non-écrite
P: document intercalaire
T: théorie ou principe à la base de l'invention
E: document de brevet antérieur, mais publié à la date de dépôt ou après cette date
D: cité dans la demande
L: cité pour d'autres raisons

&: membre de la même famille, document correspondant

Le présent rapport de recherche a été établi pour toutes les revendications

| Lieu de la recherche | Date d'achèvement de la recherche | Examinateur |
|---|---|---|
| La Haye | 06.01.1982 | POINT |

OEB Form 1503.1 06.78

BAD ORIGINAL